Europäisches Patentamt

European Patent Office

Office européen des brevets

(19)

(11) **EP 0 755 120 A1**

(12) **EUROPEAN PATENT APPLICATION**

(43) Date of publication:
**22.01.1997 Bulletin 1997/04**

(51) Int Cl.6: **H03L 7/183**, H03L 7/089

(21) Application number: **96305289.9**

(22) Date of filing: **18.07.1996**

(84) Designated Contracting States:
**DE GB NL**

(30) Priority: **18.07.1995 JP 181354/95**

(71) Applicant: **NEC CORPORATION**
**Tokyo (JP)**

(72) Inventor: **Ichimura, Nobuhiko,**
**c/o NEC Yamagata, Ltd.**
**Yamagata-shi, Yamagata (JP)**

(74) Representative: **Moir, Michael Christopher et al**
**Mathys & Squire**
**100 Grays Inn Road**
**London WC1X 8AL (GB)**

(54) **Phase-locked loop circuit**

(57)     A PLL circuit is disclosed which has a charge pump circuit responding to a phase detection signal and producing a control current for controlling an oscillation frequency of a VCO. There is further provided a control circuit for controlling current capability of the charge pump circuit in response to data indicative of a frequency division ratio to be set in a programmable divider for frequency-dividing the oscillation signal from the VCO.

# Fig.3.

EP 0 755 120 A1

**Description**

The present invention relates to a phase-locked loop (PLL) circuit and, more particularly, to such a PLL circuit that is used as an local oscillator in a tuner part of a television (TV) set, a radio receiver and so on.

As is well known in the art, in a PLL circuit in which a programmable divider is employed to frequency-divide an oscillation signal from a voltage-controlled oscillator (VCO), the frequency of the oscillation signal can be controlled to a desired value by changing a frequency division ratio set in the programmable divider. Accordingly, the VCO of the PLL circuit can be used as a local oscillator of a tuner for a TV set. The tuner is thus made small in size and inexpensive.

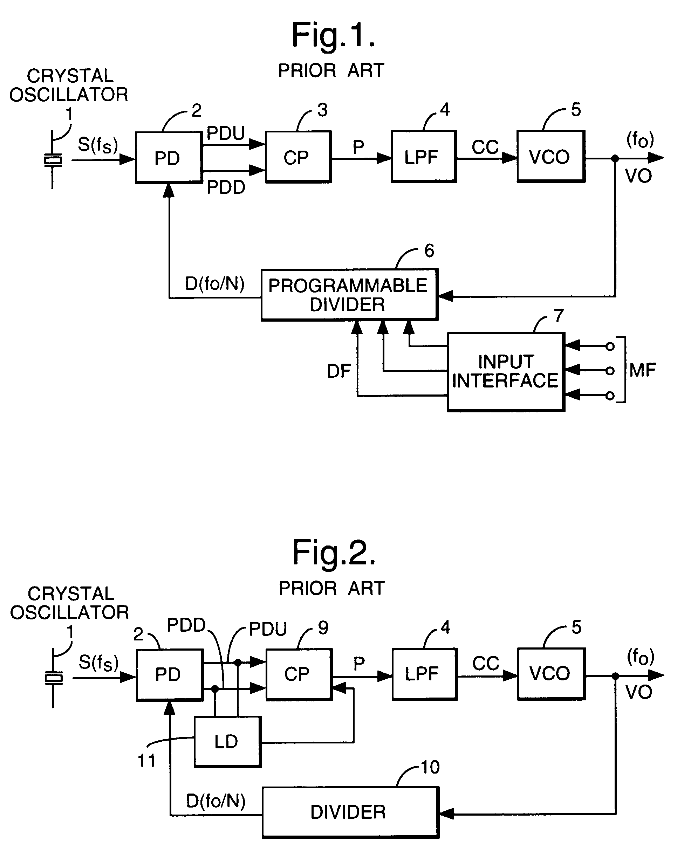

Referring now to Fig. 1, there is shown a PLL circuit according to the prior art for a tuner. This PLL circuit includes a reference oscillator 1 such as a crystal oscillator, a phase comparator (PD) 2, a charge pump circuit (CP) 3, a low pass filter (LPF) 4, a voltage-controlled oscillator (VCO) 5, a programmable divider 6 and an input interface circuit 7, which are connected as shown.

In operation, the reference oscillator 1 generates a reference signal S having a reference frequency $f_s$. The PD 2 compares the phase of the reference signal S with that of a divided signal D derived from the divider 6 and generates a positive phase difference signal PDU or a negative phase difference signal PDD in accordance with a difference in phase between the divided signal D and the reference signal S, these signals PUD and PDD being in turn supplied to the CP 3. In response thereto, the CP 3 generates and supplies a charging/discharging current signal P to the LPF 4, by which an oscillation control signal CC is produced. The VCO oscillator 5 is controlled in frequency by the oscillation control signal CC to generate the oscillating signal VO having an output frequency $f_o$ thus controlled. The signal VO is supplied to and thus frequency-divided by the programmable divider 6 in accordance with a frequency division ratio N set therein. This ratio N is based on the division ratio data DF supplied from the input interface 7 responsive to control information MF supplied thereto.

In such a manner as described above, the frequency $f_o$ of the oscillation signal VO is represented as follows:

$$f_o = N \times f_s.$$

Accordingly, by changing the division ratio, the signal VO can be controlled in frequency. The signal VO of the VCO 5 is thus usable as a local oscillation signal for tuning a desired broadcasting signal.

It is required for the PLL circuit to shorten a period of time for reaching a frequency stabilization condition, i.e., to shorten the so-called lock-up time, as well as to reduce a carrier to noise (C/N) ratio. In the PLL circuit as shown in Fig. 1, however, the current capability of the CP 3 is designed to be constant. For this reason, the PLL circuit cannot satisfy the above requirements.

Therefore, an improved PLL circuit is disclosed in Japanese Patent Laid-Open Publication Hei 2-113726. The PLL circuit disclosed is shown in Fig. 2.

In this circuit, there is provided a variable charge pump circuit 9 in place of the CP 3 of Fig. 1. The current capability of the CP 9 is controlled by a phase-lock detector 11 which detects whether or not the signal D is locked in phase with the signal S in response to the outputs PDU and PDD of the PD 2. In the case of an unlocked phase state of these two signals due to a change in the frequency-division ratio of the divider 10, the LD 11 causes the PD 9 to enhance the current capability for charging and discharging the LPF. The response time of the VCO 5 is thereby decreased. In the case of a phase-locked state, on the other hand, the CP 9 is controlled to have small current capability by the LD 11. Accordingly, even when the PD 2 would produce the signal PDU or PDD due to a noise, the CP 9, the LPF 4 and the VCO 5 would be less responsive thereto. The undesired change in frequency of the VCO is thus prevented.

It is further required for a PLL circuit as a tuner of a TV set to deal with a wide change in frequency, since the tuner of a TV set manipulates a frequency band of from a VHF band to a UHF band. That is, the VCO is required to change in frequency from 80 MHz to 930 MHz. For-this reason, even when the PLL circuit as shown in Fig. 2 is employed, the fluctuation in loop gain between a high frequency band (UHF band) and a low frequency band (VHF band) becomes very large, thereby producing a considerable difference therebetween in lock time and C/N ratio.

It is, therefore, an object of at least the preferred embodiments of the present invention to provide a further improved PLL circuit.

It is another such object to provide a PLL circuit suitable for being incorporated in a TV set.

It is still another such object to provide a PLL circuit shortening a lock-up time and enhance a C/N ratio over a wide range frequency.

Accordingly, in a first aspect the present invention provides a phase-locked loop circuit comprising an oscillator generating an oscillation signal, a frequency divider frequency-dividing said oscillation signal in response to data indicative of a frequency division ratio, a control unit responsive to an output of said frequency divider to control an oscillation frequency of said oscillator, and a gain variation circuit responding to data to be set in said frequency divider to vary a control gain of said control unit.

In a second aspect, the present invention provides a phase-locked loop circuit comprising an oscillator, a frequency divider frequency-dividing an output of said oscillator in response to a frequency division ratio, a phase detector generating detection data indicative of a difference in phase between a reference signal and an output signal of said frequency divider, a charge pump circuit responding to said detection data to produce a control current for controlling an oscillation frequency of said oscillator, a data control circuit producing and setting data indicative of a frequency division ratio in said frequency divider, and a current variation circuit responding to said data to vary said control current of said charge pump circuit.

A PLL circuit according to the above is featured by employing a charge pump circuit having a controllable current capability and by controlling the current capability of the charge pump circuit in response to frequency-division data to be set into a frequency divider.

With the above feature, when the frequency division ratio is changed to a high value to enhance the oscillation frequency of a VCO for the purpose of, for example, receiving a broadcasting signal of a UHF band, the charge pump circuit is changed to drive and control the VCO with a relatively high or strong current capability. On the other hand, when the frequency division ratio is changed by a lesser amount, the current capability of the charge pump circuit is not changed.

Accordingly, the fluctuation in damping factor can be suppressed even when the oscillation frequency of the VCO is changed widely, resulting in suppressing a large change in lock-up times and C/N ratio over a wide range from the UHF and VHF bands.

Preferred features of the present invention will now be described, purely by way of example only, with reference to the accompanying drawings, in which:-

Fig. 1 is a block diagram of a PLL circuit according to a prior art;
Fig. 2 is a block diagram of a PLL circuit according to an another prior art;
Fig. 3 is a block diagram of a PLL circuit according to an embodiment of the present invention;
Fig. 4 is a block diagram of a TV set having a PLL circuit shown in Fig. 3;
Fig. 5 is a block diagram of an input interface circuit 7, a charge pump controller 8 and a charge pump circuit 3A shown in Fig. 3;
Fig. 6 is a detailed block diagram of the input interface 7 shown in Fig. 3;
Fig. 7 is a timing chart of a set of signal data MF shown in Fig. 6;
Fig. 8 is a circuit diagram of the charge pump current control circuit 8 and the charge pump circuit 3A shown in Fig. 3;
Fig. 9 is a graph representative of current capability to frequency division data of the charge pump circuit 3; and
Fig. 10 is a graph representative of a damping factor to the frequency division data of the PLL circuit shown in Fig. 3.

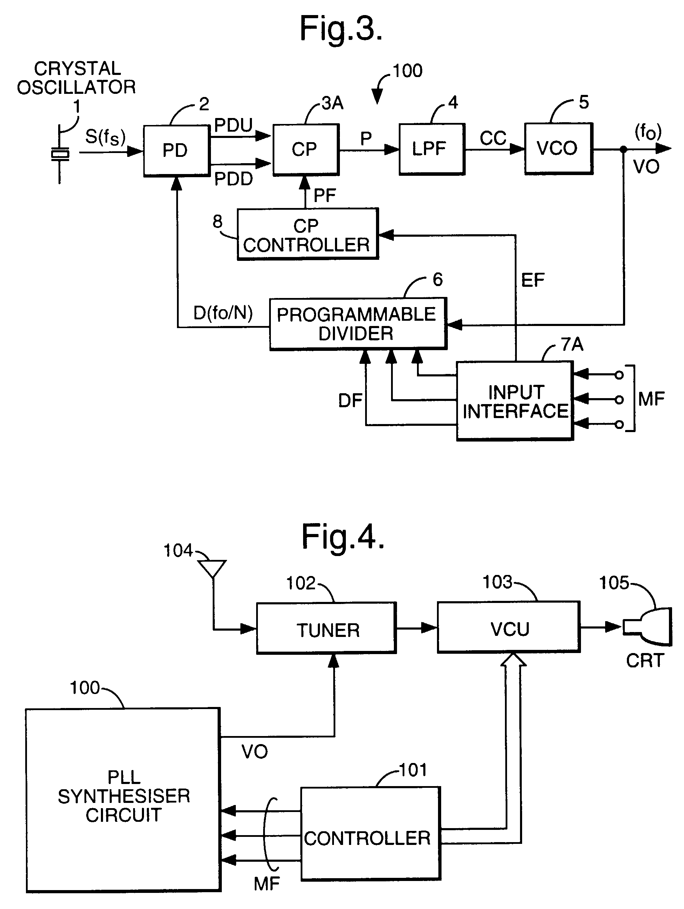

Referring now to Fig. 3, there is shown a PLL circuit 100 in accordance with an embodiment of the present invention, in which the same components as those shown in Figs. 1 and 2 are denoted by the same reference numerals or symbols to omit the further description thereof. In this circuit 100, there is provided a charge pump circuit (CP) 3A having a variable or controllable current capability. In this embodiment, the current capability of the CP 3A can be controlled in four steps, which will be described later in detail, in response to current control data PF. This data PF is produced by a charge pump (CP) controller 8 in response to control data EF which is generated by an input interface circuit 7A in response to frequency division ratio setting data DF. The input interface 7A further produces and sets frequency division ratio DF into the divider 6 in response further to the data MF, similar to the circuits shown in Figs. 1 and 2.

The oscillation signal VO of the VCO 5 of the PLL circuit 100 thus constructed is employed as a local oscillation signal for a tuner of a TV set, as shown in Fig. 4. Specifically, the local oscillation signal VO from the PLL synthesizer circuit 100 is supplied to a tuner 102 provided with an antenna 104, thereby being tuned to a desired broadcasting signal. This signal is processed by a video signal processing and control unit (VCU) under the control of the controller 101 to provide a video signal which is in turn supplied to a cathode-ray tube (CRT) 105. The controller 101 further supplies the data MF to obtain a different local oscillation signal to tune to another broadcasting signal.

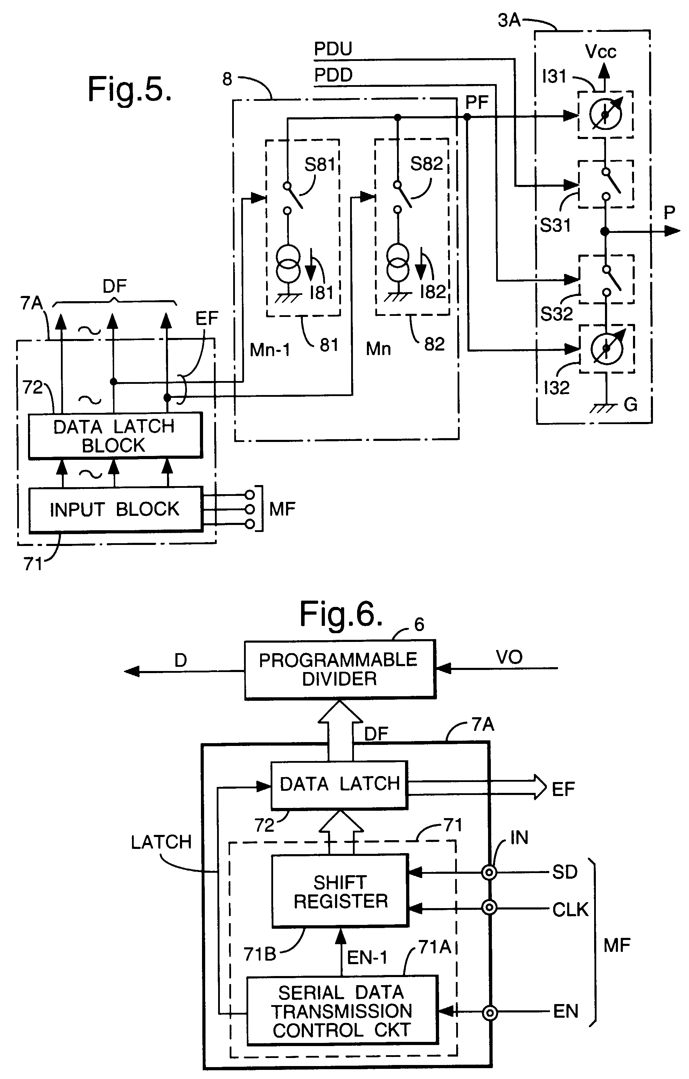

Referring to Fig. 5, the input interface 7A has an input block 71 receiving the frequency setting data MF and producing data indicative of the division ratio which is in turn temporarily latched in a data latch block 72. The latched data is then supplied to and thus set in the programmable frequency divider 6.

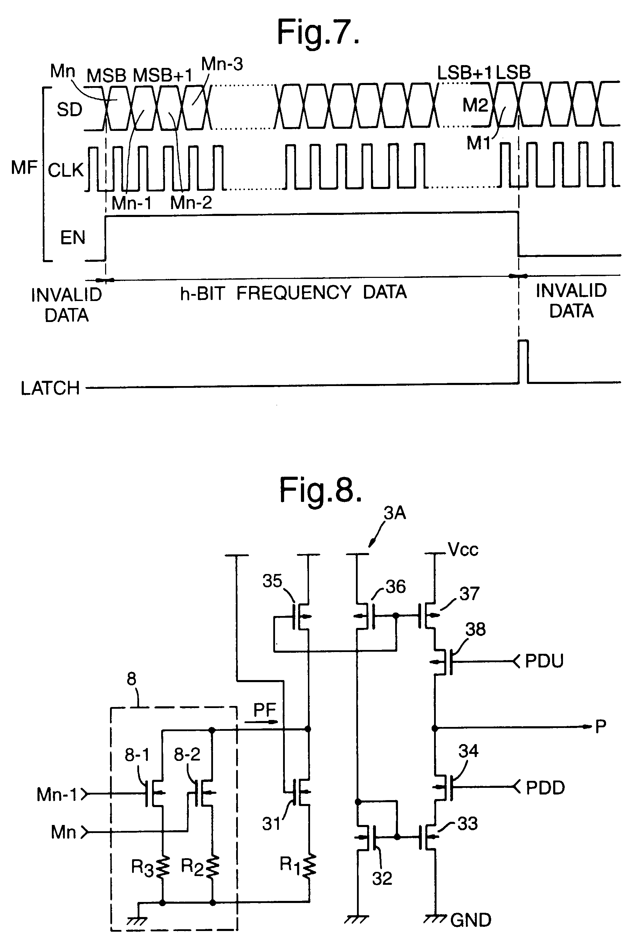

In this embodiment, the frequency division ratio is transferred in a serial data format. Specifically, as shown in Fig. 7, the frequency setting data MF comprises a serial data signal SD, a serial clock signal CLK and an enable signal EN. The serial data SD per one data transfer consists of n-bit data MI to Mn indicative of a frequency division ratio. The clock data CLK is used for bit synchronization. The enable signal EN indicates each data transfer by its active high level.

As is also apparent from Fig. 6, accordingly, a serial data transmission control circuit 71A in the input block 71 detects the change of the signal EN to the active high level and activates a shift register 71B by use of an enable signal EN-1, The shift register 71B is thereby allowed to respond to the clock signal CLK to receive the serial data SD and perform serial/parallel conversion thereof. When the enable signal EN turns to the low level, the serial data transmission control circuit 71A changes the signal EN-1 to the low level to deactivate the shift register 71B. The circuit 71A further generates and supplies a latch signal LATCH to the data latch block 72. In response thereto, the data latch 72 latches the data of the shift register 71B and then supplies it to the programmable frequency divider 6 as the frequency division ratio. In such a manner as described above, the frequency division ratio is controlled in value and the oscillation frequency of the VCO 5 is varied accordingly.

In the present embodiment, the most significant two bits (Mn and Mn-1) of the frequency division data take both "0" when the VCO 5 is controlled to oscillate in a VHF band, whereas at least one of those two bits takes "1" when the VCO 5 is controlled to oscillate in a UHF band.

Turning back to Fig. 5, accordingly, the data of the most significant two bits of the division ratio are supplied to the charge pump controller 8. This controller 8 has two current control blocks 81 and 82. The block 81 includes a switch S81 controlled by the bit Mn-1 and a current source r81 connected to the switch S81. The current control block 82 includes a switch S82 controlled by the bit Mn and a current source I82. In the present embodiment, the current values of these current sources are set to satisfy a relationship of I82 > I81. Each of the switches S81 and S82 is turned ON and OFF in response respectively to the logic "1" and "0" of the associated bit data. Accordingly, there are obtained four states 1 to 4 as indicated in the following TABLE-1 in accordance with the contents of the bits Mn and Mn-1 of the frequency division ratio.

## TABLE − 1

| STATE<br>CONTROL BITS | 1 | 2 | 3 | 4 |
|---|---|---|---|---|
| Mn | 0 | 0 | 1 | 1 |
| Mn−1 | 0 | 1 | 0 | 1 |

Since the switches S81 and S82 are connected in common at the respective one ends, the controller 8 controls or changes its output current control signal PF in four steps in accordance with the above states 1 to 4. For example, in state 1, the signal PF takes the minimum level. In state 4, on the other hand, the signal PF has the maximum level.

The charge pump circuit 3A has a first variable current source I31 connected to a power supply level $V_{cc}$, a second variable current source I32 connected to a ground level GND, and switches S31 and S32 each connected between an output node P and the associated one of the variable current sources I31 and I32. The switch S31 is controlled by the positive phase difference signal PDU from the PD 2, and the switch S32 is controlled by the negative phase difference signal PDD. Each of the variable current sources I31 and I32 produces a current which is controlled or varied by the current control signal PF. Accordingly, each of the current sources I31 and I32 also changes its output current in four steps. Of course, the current control signal PF taking the maximum level causes each of the current sources I31 and I32 to produce a current at the maximum level.

The charge pump current control circuit 8 and the charge pump circuit 3A are constructed as shown in Fig. 8. Specifically, the switches S81 and S82 comprise N-channel MOS transistors 8-1 and 8-2, respectively, and the current sources I81 and I82 comprise resistors R2 and R3, respectively. The resistor R3 is larger in resistance value than the resistor R2.

On the other hand, the CP 3A comprises four N-channel MOS transistors 31 to 34, four P-channel MOS transistors 35 to 38 and one resistor R1, which are connected as shown.

Accordingly, so long as the most significant two bits Mn and Mn-1 of the frequency division data take both "0", i. e., so long as the frequence division data is changed to cause the VCO 5 to vary in frequency within the VHF band, both of the transistors 8-1 and 8-2 are kept non-conductive, and hence a current flowing through the resistor R1 is derived as a charging current and a discharging current for the LPF 4.

When the bit Mn-1 takes "1" in order to tune to a certain broadcasting signal in the UHF band, the transistor 8-1 is rendered conductive. Accordingly, a sum of the currents flowing through the resistors R1 and R3 is used as a charge pumping current P for the LPF 4.

When the bit Mn takes "1" to tune to another broadcasting signal having higher frequence in the UHF band, the transistor 8-2 is in turn made conductive. The transistor 8-1 is changed to be non-conductive. Accordingly, a sum of currents flowing through the resistors R1 and R2 becomes the current P for charging and discharging the LPF 4.

In a similar manner, the bits Mn-1 and Mn both taking "1" turn the transistors 8-1 and 8-2 ON, so that a sum of currents flowing through the resistors R1 to R3 is used as the current P for the LPF 4.

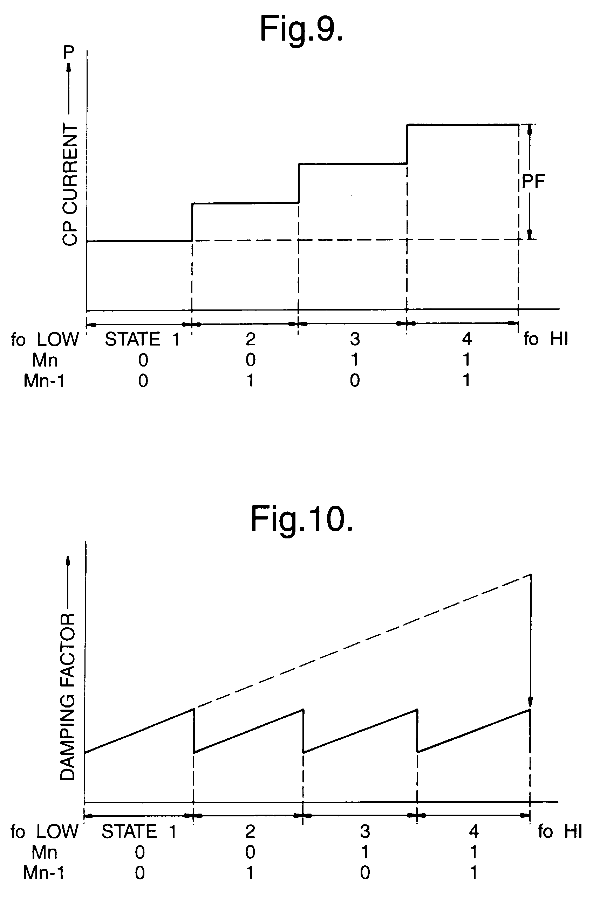

Thus, the PLL circuit according to the above embodiment shifts to a phase-locked state in a shortened lock-up time over the wide range frequency. In other words, the change in damping factor is suppressed over the wide range in frequency, as shown in Fig. 10 which indicates a damping factor with respect to the afore-mentioned states 1 to 4. The term "damping factor" as used herein means especially the amplitude of a transient characteristic. A damping factor in the prior art increases in direct proportion to the increase in frequency as shown by a broken line. In contrast, a damping factor in the present embodiment is suppressed toward the increasing frequency as shown by a solid line. For this reason, as the state 1 sequentially shifts to the state 2, 3 and 4, then the current level of the charge pump signal P is increased stepwise. Therefore, the rate of charging/discharging operation of the low pass filter to be increased, thus suppressing the increase in the damping factor.

It is apparent that the present invention is not limited to the illustrate embodiment, but may be modified and changed without departing from the scope of the invention. For example, one bit or three or more bits of the frequency division ratio may employed to vary current capability of the CP.

Each feature disclosed in this specification (which term includes the claims) and/or shown in the drawings may be incorporated in the invention independently of other disclosed and/or illustrated features.

The text of the abstract filed herewith is repeated here as part of the specification.

A PLL circuit is disclosed which has a charge pump circuit responding to a phase detection signal and producing a control current for controlling an oscillation frequency of a VCO. There is further provided a control circuit for controlling current capability of the charge pump circuit in response to date indicative of a frequency division ratio to be set in a programmable divider for frequency-dividing the oscillation signal from the VCO.

## Claims

1. A phase-locked loop circuit comprising an oscillator generating an oscillation signal, a frequency divider frequency-dividing said oscillation signal in response to data indicative of a frequency division ratio, a control unit responsive to an output of said frequency divider to control an oscillation frequency of said oscillator, and a gain variation circuit responding to data to be set in said frequency divider to vary a control gain of said control unit.

2. The circuit as claimed in Claim 1, wherein said data consists of a plurality of bits and said gain control circuit responds to a part of said bits of said data, the control gain of said control unit being thereby kept constant so long as said part of said bits remains unaltered.

3. The circuit as claimed in Claim 2, wherein said part of said bits comprises at least a most significant bit of said bits.

4. The circuit as claimed in any preceding claim, wherein said oscillation signal is used as an local oscillation signal for a tuner employed in a television set, said control gain of said control unit being increased when said oscillation signal is controlled to tune a broadcasting signal in a UHF band.

5. A phase-locked loop circuit comprising an oscillator, a frequency divider frequency-dividing an output of said oscillator in response to a frequency division ratio, a phase detector generating detection data indicative of a difference in phase between a reference signal and an output signal of said frequency divider, a charge pump circuit responding to said detection data to produce a control current for controlling an oscillation frequency of said oscillator, a data control circuit producing and setting data indicative of a frequency division ratio in said frequency divider, and a current variation circuit responding to said data to vary said control current of said charge pump circuit.

6. The circuit as claimed in Claim 5, wherein said charge pump controller has a current source producing said control current, said current source having a current control node and producing said control current with a first value when said current control node is in a first state and with a second value when said current control node is in a second state.

7. The circuit as claimed in Claim 6, wherein said current variation circuit responds to a predetermined bit of said data and brings said current control node into said first state when said predetermined bit assumes a first logic level and into said second state when said predetermined bit assumes a second logic level.

# Fig.1.
## PRIOR ART

CRYSTAL
OSCILLATOR
1

$S(f_S)$ → **PD** (2) — PDU → **CP** (3) — P → **LPF** (4) — CC → **VCO** (5) → $(f_O)$ VO

PDD

$D(f_O/N)$ ← **PROGRAMMABLE DIVIDER** (6)

DF ← **INPUT INTERFACE** (7) ← MF

# Fig.2.
## PRIOR ART

CRYSTAL
OSCILLATOR
1

PDD    PDU

$S(f_S)$ → **PD** (2) → **CP** (9) — P → **LPF** (4) — CC → **VCO** (5) → $(f_O)$ VO

**LD**

11

$D(f_O/N)$ ← **DIVIDER** (10)

# Fig.3.

100

CRYSTAL
OSCILLATOR
1

S(f$_S$)

PD
2

PDU

PDD

CP
3A

P

LPF
4

CC

VCO
5

(f$_O$)

VO

PF

CP
CONTROLLER
8

EF

D(fo/N)

PROGRAMMABLE
DIVIDER
6

DF

INPUT
INTERFACE
7A

MF

# Fig.4.

104

102

TUNER

103

VCU

105

CRT

100

PLL
SYNTHESISER
CIRCUIT

VO

101

CONTROLLER

MF

## Fig.5.

## Fig.6.

# Fig.7.

# Fig.8.

# Fig.9.

| fo LOW | STATE 1 | 2 | 3 | 4 | fo HI |
|--------|---------|---|---|---|-------|
| Mn | 0 | 0 | 1 | 1 | |
| Mn-1 | 0 | 1 | 0 | 1 | |

# Fig.10.

| fo LOW | STATE 1 | 2 | 3 | 4 | fo HI |
|--------|---------|---|---|---|-------|
| Mn | 0 | 0 | 1 | 1 | |
| Mn-1 | 0 | 1 | 0 | 1 | |

| | European Patent Office | EUROPEAN SEARCH REPORT | Application Number EP 96 30 5289 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-5 362 990 (ALVAREZ JOSE  ET AL) 8 November 1994<br>* column 2, line 33 - column 8, line 3; figures 1,2 *<br>--- | 1-7 | H03L7/183<br>H03L7/089 |
| X | US-A-5 339 050 (LLEWELLYN WILLIAM D) 16 August 1994<br>* column 1, line 7 - line 13 *<br>* column 4, line 3 - column 6, line 8; figures 2,3 *<br>--- | 1-7 | |
| X | RCA REVIEW,<br>vol. 47, March 1986, PRINCETON  US,<br>pages 78-87, XP002011878<br>RICHARD YEAGER:  "Loop Gain Compensation in Phase-Locked Loops"<br>* page 83, line 3, paragraph 34 - page 87, last line; figures 3-5 *<br>--- | 1-7 | |
| X | PROCEEDINGS OF THE CUSTOM INTEGRATED CIRCUITS CONFERENCE, BOSTON, MAY 3 - 6, 1992,<br>no. CONF. 14, 3 May 1992, INSTITUTE OF ELECTRICAL AND ELECTRONICS ENGINEERS,<br>pages 24.1.1-24.1.6, XP000340947<br>BITTING R F ET AL:  "A 30 - 128 MHZ FREQUENCY SYNTHESIZER STANDARD CELL"<br>* page 24.1.1, column 2, line 1 - page 24.1.2, column 2, line 40 *<br>* page 24.1.3, column 2, line 7 - line 27 *<br>* figures 1,2,4 *<br>----- | 1-3,5-7 | TECHNICAL FIELDS SEARCHED     (Int.Cl.6)<br><br>H03L |

The present search report has been drawn up for all claims

| Place of search | Date of completion of the search | Examiner |
|---|---|---|
| THE HAGUE | 28 August 1996 | Balbinot, H |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
.................................................................................
& : member of the same patent family, corresponding
   document

EPO FORM 1503 03.82 (P04C01)

11